# EUROPÄISCHE PATENTSCHRIFT

(11) **EP 0 443 439 B1**
(45) Veröffentlichungstag und Bekanntmachung des Hinweises auf die Patenterteilung: **18.10.1995**
(21) Anmeldenummer: 91102082.4
(22) Anmeldetag: 14.02.1991
(51) Int. Cl.: H01L 27/108, H01L 21/8242

(54) **Ein-Transistor-Speicherzellenanordnung und Verfahren zu deren Herstellung**
One-transistor-storage cell device and method for making the same
Dispositif de mémoire comprenant un transistor et son procédé de fabrication

(30) Priorität: 23.02.1990 DD 338097
(43) Veröffentlichungstag der Anmeldung: 28.08.1991
(60) Teilanmeldung: 94101691.7
(73) Patentinhaber: INSTITUT FÜR HALBLEITERPHYSIK FRANKFURT (ODER) GmbH, 15204 Frankfurt (Oder) (DE)
(72) Erfinder: Temmler, Dietmar, Dr.Ing., O-1200 Frankfurt/Oder (DE)
(74) Vertreter: Bomberg, Siegmar

(56) Entgegenhaltungen:
- EP-A- 0 258 657
- EP-A- 0 404 553
- DE-A- 3 918 924
- PATENT ABSTRACTS OF JAPAN, Band 13, Nr. 295 (E-783)(3643), 7. Juli 1989 ; & JP-A-1 074 752
- IEEE TRANSACTIONS ON ELECTRON DEVICES, Band 35, Nr. 10, Teilen 1/2, Oktober 1988, Seiten 1591-1595, New York, US; S.-I. KIMURA et al.: "An optically delineated 4.2-mum2 self-aligned isolated-plate stacked-capacitor DRAM cell"

## Beschreibung

Die Erfindung betrifft eine Ein-Transistor-Speicherzellenanordnung und ein Verfahren zu deren Herstellung, insbesondere für höchstintegrierte dynamische Halbleiterspeicher.

Die Grundstruktur für dynamische Halbleiterspeicher nach dem Prinzip der Ein-Transistor-Zelle besteht aus einem MOS-Auswahltransistor und einem Speicherkondensator mit einer Speicherkapazität von 30 bis 50 fF, der die logische Information als gespeicherte Ladung enthält. Der Auswahltransistor ist über eine Wortleitung ansteuerbar. Sein Draingebiet ist mit einer Elektrode des Speicherkondensators verbunden, während sein Sourcegebiet nach außen über eine Bitleitung mit in Bitleitungsrichtung liegenden Sourcegebieten weiterer Speicherzellen verbunden ist. In dRAM-Speichern bis 1 Mbit werden die Speicherkondensatoren in der Regel durch einen hochdotierten Substratflächenabschnitt, einem darüberliegenden Speicherdielektrikum (in der Regel Siliziumdioxid) und einer Polysiliziumzellplatte als planare Anordnung ausgebildet.

Um die Integrationsdicte zu erhöhen, werden Zellkonzepte mit einem dreidimensionalen Speicherkondensator als Trench- oder Stapelkondensator (STC; Stacked capacitor) oder in Mischvarianten realisiert. Das STC-Zellkonzept zeichnet sich gegenüber dem Trenchzellkonzept vorteilhaft durch eine weitgehende elektrische Entkopplung der Speicherkapazität vom aktiven Silizium aus. Dadurch bleibt das aktive Silizium in der Regel bis auf die Drainkontaktierung einer unteren Speicherelektrode morphologisch ungestört. Infolgedessen werden die für die Trenchzellenkonzepte typischen Substratdefekte beziehungsweise die zur Beseitigung dieser Defekte in der Regel notwendigen technologischen Maßnahmen und die laterale Wechselwirkung benachbarter Speicherkapazitäten über das Siliziumsubstrat prinzipiell vermieden sowie eine natürliche, ohne gesonderte Maßnahmen vorhandene, hohe ALPHA-Immunität gewährleistet. Bei der konventionellen STC-Speicherzelle besteht der Speicherkondensator aus zwei übereinanderliegenden dotierten Polysiliziumschichten mit dazwischenliegendem Speicherdielektrikum. Die untere Polysiliziumschicht fungiert dabei als Speicherelektrode und ist mit dem Draingebiet des Auswahltransistors verbunden. Die obere Polysiliziumschicht fungiert als gemeinsame Zellplatte einer Speichermatrix. Der Elektrodenstapel überlappt das Gate des Auswahltransistors (vgl. Koyanagi, IEDM Tech. Dig. 1978, S. 348-351).

Aus EP-PS 0191612 ist eine verbesserte STC-Variante bekannt, bei der die Zellplatte den Rand der Speicherelektrode überlappt, wodurch deren Seitenflanke als Flächenbeitrag für eine höhere Speicherkapazität gewonnen wird. Durch die gleichzeitige Auffüllung der Bitleitungskontaktfenster mit der Herstellung der Speicherelektrode wird außerdem das Problem des Bitleitungsabrisses an den Flanken des Bitleitungskontaktfensters gelöst. Diese Vorteile können bekannterweise (EP-PS 0263941) durch Erhöhung der Dicke der Speicherelektrode verstärkt werden.

Weiterhin ist ein Verfahren (EP-PS 0223616) bekannt, bei dem durch Vertiefung des Drainkontaktfensters in das Siliziumsubstrat hinein mittels eines RIE-Prozesses ein Graben erzeugt wird, der durch seine Topologie nach Abscheidung der Speicherelektrodenschicht ebenfalls zu einer Vergrößerung der kapazitiven Fläche beiträgt.

Eine noch größere Speicherkapazität ist durch Kombination der Reliefbeiträge einer dicken Speicherelektrode und eines Grabens im Drainkontaktfenster erreichbar (IEDM Tech. Dig., 1988, S. 600-603).

Durch die aufgeführten dreidimensionalen SIC-Varianten wird ein topologisches Relief erzeugt, das abrißfreie Bitleitungskontaktierung erschwert, wenn die Bitleitung über den Speicherkondensator geführt wird. Zur Beseitigung dieses Nachteiles ist aus IEDM Tech. Dig. 1988, S. 596-599 eine Lösung bekannt, in welcher die Bitleitung unter der Speicherkapazität durchgeführt wird. Bei diesem DASH-STC-Konzept erfolgt die Bitleitungsherstellung nach der Fertigstellung des Auswahltransistors derart, daß die Bitleitung seitlich am späteren Drainkontaktfenster für die Speicherelektrode vorbeigeführt wird. Damit ist die prinzipielle Möglichkeit erschlossen, den STG-Komplex vertikal zu vergrößern, ohne daß Probleme bei der Bitleitungsstrukturierung und -kontaktierung auftreten.

Desweiteren ist aus EP-PS 0295709 ein STC-Zellenkonzept ("fin-Typ") bekannt, bei dem die Speicherelektrode aus einem untereinander kontaktierten Mehrfach-Polysiliziumstapel besteht, der den Auswahltransistor überlappt. Diese Polysilizium"fins" werden allseitig vom Speicherdielektrikum und einer gemeinsamen Polysilizium-Zellplatte umschlossen.

Ema u. a. beschreiben in IEDM Tech. Dig. 1988, S.592-595 beide Möglichkeiten der Bitleitungsführung unter- und oberhalb einer Speicherkapazität vom "fin-Typ".

Für Speicher größer gleich 16 MdRAM muß die Bitleitung unter dem STC-Komplex angeordnet sein. Derartig komplex strukturierte Speicherelektroden sind fertigungstechnisch schwer beherrschbar (vgl. IEDM Tech. Dig. 1989, S. 31-34). Außerdem beschreiben Inoue u. a. ebenda mit einem SSC-Zellenkonzept für 64 MdRAM bzw. 256 MdRAM eine Lösung, bei der die Bitleitung unter dem STC-Komplex angeordnet ist und sich Speicherelektroden vom "fin-Typ" bis in benachbarte Zellengebiete hinein wechselseitig überlappen.

Nachteilig an beiden letztgenannten Lösungen, gleichgültig ob die den Speicherelektrodenstapel bildenden Polysilizium"fins" nur das eigene Zellengebiet oder auch die benachbarten Zellengebiete überlappen, ist, daß während der Herstellung eine Bearbeitungsphase auftritt, bei der die horizontal übereinander angeordneten Polysilizium"fins" freitragend mehreren Verfahrensschritten ausgesetzt sind. Diese Verfahrensschritte, wie Naßätz- und Reinigungsschritte, Oxydation, Isolator- und Polysilizium-CVD-Abscheidungen, stellen für diese empfindlichen, freitragenden Speicherelektrodenkonfigurationen beträchtliche mechanische, chemische und thermische Beanspruchungen dar.

Bedingt durch das Herstellungsverfahren zur Erzeugung der Polysilizium"fins" und der Forderung, eine große speicherwirksame Strukturoberfläche zu erzielen, sind die "fins" vorzugsweise sehr dünn (kleiner gleich 100 nm) bei zugleich großem Länge- zu Dicke-Verhältnis und nur linienhaft mit den anderen "fins" derselben Speicherelektrode bzw. dem einkristallinen Siliziumsubstrat verwachsen. Dadurch ist die Stabilität solcher freitragenden Speicherelektroden gering und infolgedessen die Ausbeute bei der Herstellung der Speicherzelle negativ beeinflußt.

Weiterhin ist nachteilig, daß die zwischen den Polysilizium"fins" liegenden, langen und schmalen Zwischenräume parallel zur Siliziumsubstratoberfläche liegen und zum Beispiel durch Naßätz- und Reinigungsprozesse nur über senkrecht dazu liegende, schachtförmige Kanäle erreichbar sind. Dadurch ergeben sich insbesondere bei der Oberflächenbehandlung der freitragenden Polysilizium"fins" durch Naßätz- und Reinigungsprozesse, aber auch für die folgenden CVD-Beschichtungsprozesse für den Speicherisolator und die Polysilizium-Zellplatte ungünstige Antransport-, Abtransport- und Austauschbedingungen für flüssige und gasförmige Medien in den Mikrobereichen der Speicherelektrodenkonfiguration. Diese Prozesse müssen jedoch die notwendige hohe Ausgangsqualität der Speicherelektrodenoberfläche bzw. die hohe Qualität des in der Regel sehr dünnen (kleiner gleich 10 nm Siliziumdioxid-Äquivalent), durchschlagsfesten (größer gleich 6 MV/cm) Speicherdielektrikums und der Zellplatte mit hoher Ausbeute, reproduzierbar sichern.

Aus Patent Abstracts of Japan, Band 13, Nr. 295 (E-783) (3643), 7.7.89 und JP-A-1 074 752 ist eine STC-Speicherzellenanordnung bekannt, deren Speicherelektrode aus einer konzentrischen Anordnung vertikal gerichteter, ringförmig geschlossener, leitfähiger Lamellen besteht, deren Wandstärke und gegenseitiger Abstand äquidistant und etwa gleichgroß sind.

Desweiteren ist aus DE-A-3 918 924 eine Speicherelektrode einer vertikal-lamellenförmigen Konstruktion bekannt.

Ferner ist aus dem unter Art. 54(3) EPÜ fallenden Dokument EP-A-0 404 553 eine STC-Speicherzellenanordnung bekannt, die eine becherförmige Speicherelektrode aufweist.

Ziel der Erfindung sind eine Ein-Transistor-Speicherzellenanordnung für dynamische Halbleiterspeicher und ein Verfahren zu deren Herstellung, die die Qualität und Stabilität der Speicherelektroden des STC-Komplexes mit hoher Reproduzierbarkeit wesentlich verbessern, die Ausbeute des Herstellungsprozesses erhöhen und eine Steigerung der Packungsdichte gewährleisten.

Der Erfindung liegt die Aufgabe zugrunde, eine Ein-Transistor-Speicherzelllenanordnung für dynamische Halbleiterspeicher und ein Verfahren zu deren Herstellung zu schaffen, welche für flüssige und gasförmige Medien bei der Durchführung von Naßätz- und Reinigungsprozessen sowie von Beschichtungsverfahren, insbesondere bei der Ausbildung des STC-Komplexes, günstige Bedingungen gewährleisten.

Erfindungsgemäß wird die Aufgabe durch eine Ein-Transistor-Speicherzelle für höchstintegrierte dynamische Halbleiterspeicher gemäß Anspruch 1 und ein Verfahren zu deren Herstellung gemäß Anspruch 4 gelöst.

Weitere Ausgestaltungen der Erfindung sind den abhängigen Ansprüchen zu entnehmen.

Nachfolgend soll die Erfindung wie in den Figuren 1a-1c und 3a-3i gezeigt anhand eines Ausführungsbeispiels näher erläutert werden. Die Zeichnungen zeigen:
- Fig. 1a: Zellenkonstruktionsschema einer Speicherzellenanordnung "Bitline on STC" (ohne Zellplatte gezeichnet)
- Fig. 1b: Zellenlayout einer Speicherzellenanordnung "Bitline on STC" (ohne Bitleitung gezeichnet)
- Fig. 1c: Querschnitt einer Speicherzellenanordnung "Bitline on STC"
- Fig. 2a: Zellenkonstruktionsschema einer Speicherzellenanordnung mit "STC on Bitline" (ohne Zellplatte gezeichnet: STC-Komplex abgehoben)
- Fig. 2b: Zellenlayout einer Speicherzellenanordnung "STC on Bitline" (ohne Bitleitung gezeichnet)
- Fig. 2c: Querschnitt einer Speicherzellenanordnung "STC on Bitline"
- Fig. 3a: Lamellenstruktur der Speicherelektrode in der Draufsicht des Speicherzellenlayouts
- Fig. 3b: STC-Komplex vor RIE der dicken Hilfsisolationsschicht
- Fig. 3c: STC-Komplex vor RIE der ersten dünnen Hilfsisolationsschicht
- Fig. 3d: STC-Komplex nach RIE der ersten dünnen Hilfsisolationsschicht
- Fig. 3e: STC-Komplex nach Abscheidung der letzten auffüllenden Lamellenschicht
- Fig. 3f: STC-Komplex nach RIE des planaren Lamellenschichtstapels
- Fig. 3g: STC-Komplex nach isotroper Entfernung der Hilfsisolationsschichten
- Fig. 3h: STC-Komplex nach maskenfreier RIE-Strukturierung der Bodenplatte
- Fig. 3i: STC-Komplex Endzustand
- Fig. 4a: Speicherzellenanordnung "STC on Bitline" vor RIE des Drainkontaktfensters
- Fig. 4b: Speicherzellenanordnung "STC on Bitline" vor RIE-Strukturierung des leitenden Rings
- Fig. 4c: Speicherzellenanordnung "STC on Bitline" nach RIE-Strukturierung einer dünnen Isolationsschicht an der Innenfläche des leitenden Rings
- Fig. 4d: Speicherzellenanordnung "STC on Bitline" nach Abscheidung einer weiteren Isolationsschicht für den Isolationsmantel
- Fig. 4e: Speicherzellenanordnung "STC on Bitline" vor RIE der dicken Hilfsisolationsschicht
- Fig. 4f: Speicherzellenanordnung "STC on Bitline" nach Abscheidung der Deckisolationsschicht auf dem kompletten STC-Komplex

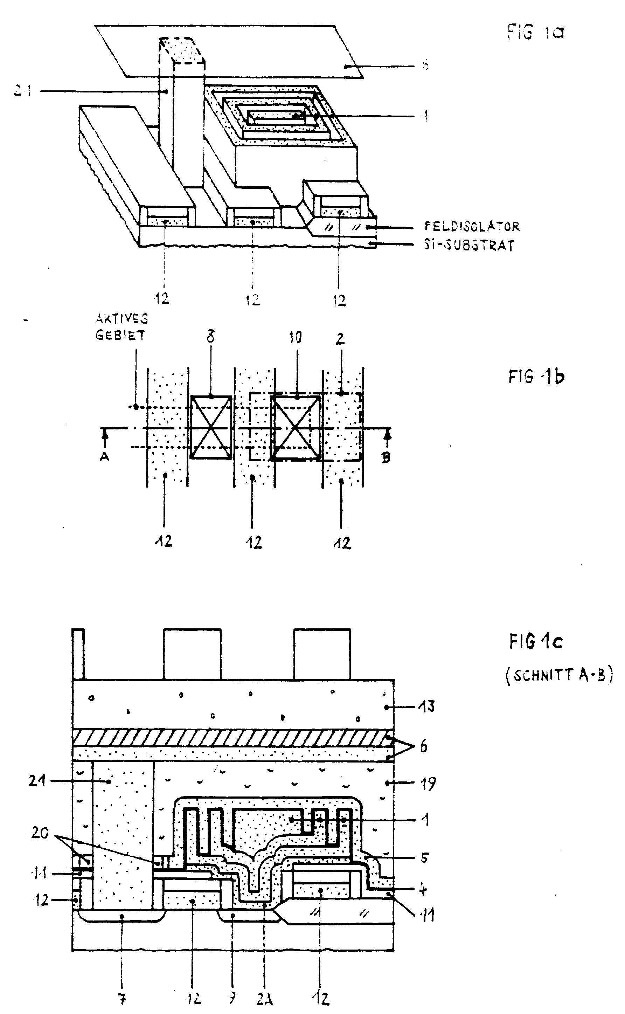

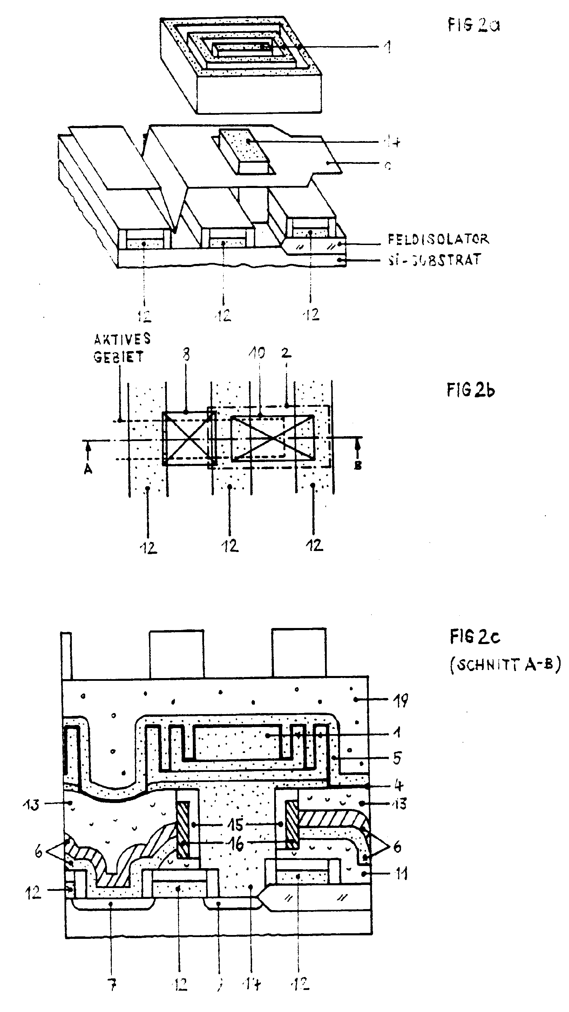

Die Realisierung der erfindungsgemäßen Ein-Transistor-Speicherzellenanordnung für dynamische Halbleiterspeicher ist zum einen, wie in Fig. 1 dargestellt, wobei Fig. 1a die Zellenkonstruktion, Fig. 1b das Zellenlayout und Fig. 1c den Querschnitt zeigt, als eine Speicherzellenanordnung mit STC on Bitline und zum anderen, wie in Fig. 2a dargestellt, wobei Fig. 2a die Zellenkonstruktion, Fig. 2b das Zellenlayout und Fig. 2c den Querschnitt zeigt, als eine Speicherzellenanordnung mit Bitline on STC möglich.

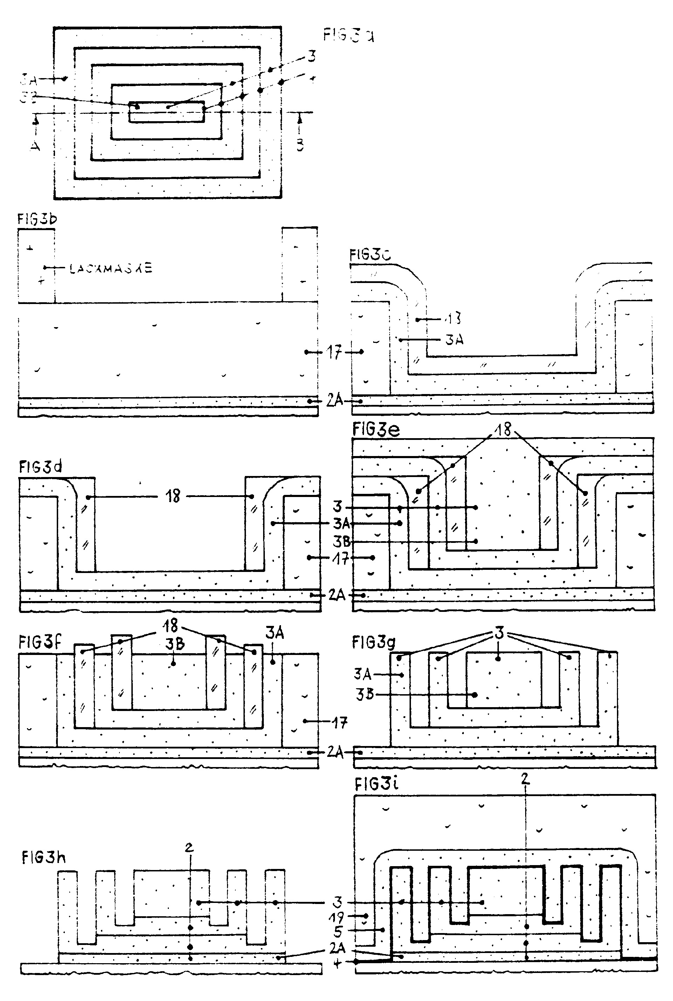

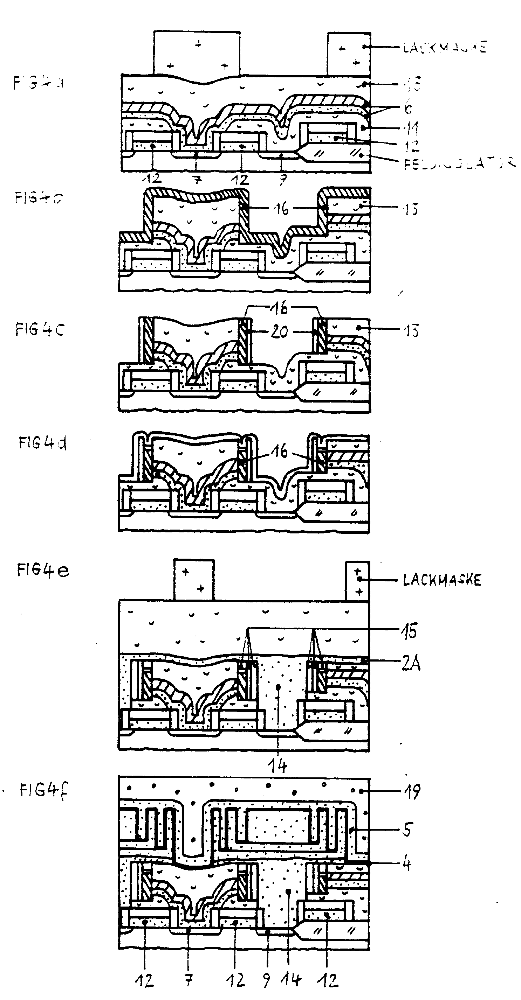

Die Herstellung einer STC-on-Bitline-Speicherzellenanordnung (Fig. 2,4) soll nachstehend näher erläutert werden. Die Herstellung einer erfindungsgemäßen Bitline-on-STC-Speicherzellenanordnung (Fig. 1) ist hinsichtlich des STC-Komplexes (Fig 3) analog und wird deshalb hier nicht weiter beschrieben.

Nach der Herstellung von n- und p-leitenden CMOS-Wannen werden in einem p-dotiertem Siliziumsubstrat mit einem LOGOS-Verfahren Feldisolationsgebiete und aktive Bereiche und im Anschluß daran LDD-MOS-Transistoren, bestehend aus isolierten Polysilizium-Wortleitungen 12 mit Siliziumdioxiddeckisolation, seitlichen Isolationsspacern und Source- 7 und Draingebieten 9 ausgebildet.

Anschließend wird eine untere Isolationsschicht 11 aufgebracht und strukturiert, die Bitleitung 6 erzeugt und über die Sourcekontaktfenster 8 an den Auswahltransistor angeschlossen, darauf eine obere Isolationsschicht 13 aufgebracht und in diese Drainkontaktfenster 10 strukturiert.

Nach Reinigung der Drainkontaktfenster 10 wird eine 100 nm dicke n-leitende Polysiliziumschicht als unterste Bodenplattenschicht 2a, die das Draingebiet 9 in Form eines leitenden Stempels 14 Kontaktiert, abgeschieden.

Im Anschluß daran wird eine 1 um dicke planarisierte Hilfsisolatorschicht 17 aufgebracht (Fig. 4e; Fig. 3b) und über eine Lackmaske mit einem anisotropen selektiven RIE-Prozeß, der auf der untersten Bodenplattenschicht 2A gestoppt wird, ein steilflankiger Durchbruch mit einer Breite von 1,6 um in die Hilfsisolatorschicht 17 eingebracht. Nach Entfernung der Lackmaske und der Durchführung eines Reinigungsprozesses wird eine n-leitende Polysiliziumschicht mit einer Dicke von 175 nm als erste leitende Lamellenschicht abgeschieden, danach eine erste dünne Hilfsisolationsschicht 18 mit einer Dicke von 180 nm aufgebracht (Fig. 3c) und anschließend durch einen anisotropen RIE-Prozeß auf allen horizontalen Flächen wieder entfernt, wobei der anisotrope Ätzprozeß auf der ersten Lamellenschicht gestoppt wird (Fig. 3d). Nach einem Reinigungsprozeß wird wiederum eine n-leitende Polysiliziumschicht abgeschieden, eine weitere dünne Hilfsisolationsschicht 18 mit einer Dicke von 180 nm aufgebracht und mit einem anisotropen RIE-Prozeß wieder entfernt, so daß die steilflankigen, vertikalen Seitenwände des Durchbruchs von einer Schicht folge aus Polysiliziumschicht und dünner Hilfsisolatorschicht 18 zweifach bedeckt sind und im Zentrum des Durchbruchs eine Restöffnung von 180 nm minimaler Breite verbleibt. Diese Restöffnung wird durch Abscheidung einer 120 nm dicken n-leitenden Polysiliziumschicht als letzte Lamellenschicht vollständig ausgefüllt (Fig. 3e).

Im Anschluß daran wird der auf der Oberfläche der dicken Hilfsisolationsschicht 17 liegende Schichtstapel aller Lamellenschichten mit einem RIE-Prozeß entfernt, wobei die Oberflächen der dicken Hilfsisolationsschicht 17 und der im steilflankigen Durchbruch verbliebenen dünnen Hilfsisolationsschichten 18 freigelegt werden und die oberen Enden der senkrecht im Durchbruch angeordneten Polysiliziumlamellen 3 voneinander getrennt werden (Fig. 3f).

Nach dem anschließenden selektiven naßchemischen Entfernen der dünnen 18 und der dicken Hilfsisolationsschichten 17 (Fig. 3g) werden die im Bereich des vorherigen steilflankigen Durchbruchs vertikal freistehenden Polysiliziumlamellen 3 durch ein anisotropes RIE-Verfahren vertikal um die Dicke der untersten Bodenplattenschicht 2A abgetragen, wobei das RIE-Verfahren auf der oberen Isolationsschicht 13 gestoppt wird. Durch dieses RIE-Verfahren erfolgt die vollständige selbstjustierende Ätzung der untersten Bodenplattenschicht 2A im Bereich außerhalb des vorherigen steilflankigen Durchbruchs und somit die Trennung der Speicherelektroden 1 benachbarter Speicherzellen, wobei die die leitenden Lamellen horizontal verbindende leitende Bodenplatte 2, die aus der untersten Bodenplattenschicht 2A und den horizontalen Teilen der Polysiliziumlamellenschichten besteht, um die Dicke der untersten Bodenplattenschicht abgedünnt, aber nicht durchtrennt wird (Fig. 3h).

Im Anschluß an diesen Ätzprozeß wird aus einer 3 nm dicken Siliziumdioxidschicht, einer 10 nm dicken LPCVD-Siliziumnitridschicht und einer Reoxidation der Siliziumnitridschicht ein ONO-Speicherdielektrikum 4 mit einer Siliziumdioxid-Äquivalentdicke von 3 nm erzeugt.

Hiernach wird eine n-dotierte Polysiliziumschicht als Zellplatte 5 mit einer Dicke von 150 nm abgeschieden und strukturiert, die die Räume zwischen den Polysiliziumlamellen 3 vollständig ausfüllt.

Abschließend wird eine planarisierende Deckisolationsschicht 19 abgeschieden und strukturiert (Fig. 3i; Fig. 4f).

Aufstellung der verwendeten Bezugszeichen:
- 1: - Speicherelektrode
- 2: - leitende Bodenplatte der Speicherelektrode
- 2A: - unterste leitende Bodenplattenschicht
- 3: - leitende Lamellen
- 3A: - äußerste Lamelle
- 3B: - innerste Lamelle
- 4: - Speicherdielektrikum
- 5: - Zellplatte
- 6: - Bitleitung
- 7: - Sourcegebiet
- 8: - Source- bzw. Bitleitungskontaktfenster
- 9: - Draingebiet
- 10: - Drainkontaktfenster
- 11: - untere Isolationsschicht
- 12: - isolierte Wortleitung
- 13: - obere Isolationsschicht
- 14: - leitender Stempel für die Drainkontaktierung
- 15: - Isolationsmantel
- 16: - leitender Ring
- 17: - dicke Hilfsisolationsschicht
- 18: - dünne Hilfsisolationsschicht
- 19: - planarisierende Deckisolationsschicht
- 20: - dünne Isolationsschicht
- 21: - planarisierter leitfähiger Stempel für die Sourcekontaktierung

## Patentansprüche

1. Ein-Transistor-Speicherzelle nanordnung für höchstintegrierte dynamische Halbleiterspeicher, bestehend aus Feldisolationsgebiet und aktivem Gebiet eines einkristallinen Halbleitersubstrates, in dem ein MOS-Auswahl-Feldeffekttransistor mit einer allseitig isolierten Wortleitung (12) und einem Source- (7) und einem Draingebiet (9) integriert ist, einer mit dem Source-Gebiet kontaktierten Bitleitung (6) sowie einer mit dem Draingebiet kontaktierten Speicherelektrode (1) eines stacked-capacitor-Speicherkondensators, dessen Deckelektrode (5) als Zellplatte aller Speicherzellen eines Speichermatrixblocks ausgebildet ist, wobei die Speicherzellenanordnung so gewählt ist,
daß die Speicherelektrode (1) aus einer konzentrischen Anordnung vertikal zur Oberfläche des einkristallinen Halbleitersubstrates gerichteter, ringförmig geschlossener, leitfähiger Lamellen besteht, deren Wandstärke und gegenseitiger Abstand äquidistant und etwa gleichgroß sind,
daß die innerste der Lamellen das Zentrum der Speicherelektrode vollständig ausfüllt,
daß jede der Lamellen zum Halbleitersubstrat hin in eine Bodenplattenschicht (2) übergeht, wodurch jede der ringförmigen Lamellen nach unten hin abgeschlossen wird, und mit ihrer zugehörigen Bodenplattenschicht (2) jeweils ein becherförmiges Element bildet,
daß jede dieser Bodenplattenschichten (2) auf der gesamten, von der zugehörigen Lamelle umschlossenen Fläche die jeweils darunterliegende größere Bodenplattenschicht (2) der nächstgrößeren, benachbarten Lamelle kontaktiert,
daß die unterste der Bodenplattenschichten (2), deren Fläche durch den Umfang der äußersten der Lamellen bestimmt ist, eine gleich große, den Kontakt zum Draingebiet (9) des MOS-Auswahltransistors vermittelnde Bodenplattenbasisschicht kontaktiert, deren Dicke geringer als die einer Bodenplattenschicht (2) ist,
daß die Speicherelektrode (1) von einer dünnen, konformen Schicht Speicherdielektrikum (4) und von einer Zellplattenschicht (5) so bedeckt ist, daß die verbleibenden Zwischenräume zwischen den Lamellen der Speicherelektrode jeder Speicherzelle durch die Zellplattenschicht (5) vollständig ausgefüllt sind und daß die Außenflanken der Speicherelektrode und die Zwischenräume zwischen Speicherelektroden benachbarter Speicherzellen bis auf entwurfsbedingte Durchbrüche ebenfalls mit der Zellplatte (5) bedeckt sind.

2. Ein-Transistor-Speicherzellenanordnung nach Anspruch 1, dadurch gekennzeichnet, daß die Lamellen unabhängig vom Relief ihrer Bodenplattenschichten (2) und unabhängig vom Relief der darunter angeordneten Speicherzellenelemente in einheitlicher Höhe über dem Niveau der Oberfläche des Halbleitersubstrates enden.

3. Ein-Transistor-Speicherzellenanordnung nach einem der vorhergehenden Ansprüche, dadurch gekennzeichnet,
daß eine Bitleitung (6) isoliert auf dem stacked-capacitor-Speicherkondensator angeordnet ist, wobei der im Sourcekontaktfenster (8) liegende Teil (21) der Bitleitung (6) stempelartig und gegenüber der Bitleitungsebene planarisiert ausgebildet ist, und daß die Drainkontaktierung der Speicherelektrode (1) durch direkten Kontakt der Bodenplattenbasisschicht (2a) mit dem Draingebiet (9) erfolgt.

4. Verfahren zur Herstellung einer Ein-Transistor-Speicherzellenanordnung nach Anspruch 1 und 2, dadurch gekennzeichnet,
daß nach Herstellung des MOS-Auswahl-Feldeffekttransistors mit allseitig isolierter Wortleitung und Source- und Draingebieten, und nach Abscheidung eines Zwischenebenenisolators und Öffnung des Drainkontaktfensters (10) eine dünne Bodenplattenbasisschicht (2a) und danach eine dicke Hilfsisolatorschicht (17), deren Dicke die Vertikalabmessung der Speicherelektrode (1) definiert, planarisiert abgeschieden wird,
daß anschließend in letztere mittels anisotroper, selektiver Plasma-Ätzung ein steilflankiger Durchbruch bis auf die Bodenplattenbasisschicht (2a) eingebracht wird, dessen Umfang die Außenabmessung der Speicherelektrode (1) bestimmt,
daß nachfolgend, beginnend mit der Abscheidung einer ersten leitfähigen Lamellenschicht (3a), abwechselnd je eine Lamellenschicht (3a) mit einer Dicke größer als die Dicke der Bodenplattenbasisschicht (2a), und eine Opferisolatorschicht (18), mit einer Dicke vergleichbar der Dicke einer Lamellenschicht (3a), abgeschieden werden, wobei zumindest jeweils nach der Abscheidung der Opferisolatorschicht (18) ein anisotroper plasmachemischer Rückätzprozeß, der auf der jeweils zuletzt abgeschiedenen Lamellenschicht (3a) selektiv stoppt, durchgeführt wird, wodurch die horizontalen Schichtbereiche der Opferisolatorschicht (18) vollständig entfernt werden, während die Opferisolatorschicht (18) an der senkrechten Wand des steilflankigen Durchbruchs verbleibt, so daß dort nach mehrfacher Wiederholung der genannten Schichtabscheide- und Rückätzprozesse eine vertikale Lamellenstruktur aus leitfähigen Lamellen (3a) und dazwischenliegenden Opferisolatorschichten (18) ausgebildet wird,
daß nach Abscheidung der letzten der leitenden Lamellenschichten (3b), die den steilflankigen Durchbruch in der dicken Hilfsisolatorschicht (17) vollständig schließt, ein anisotroper Plasmaätzschritt durchgeführt wird, der den auf der Oberfläche der dicken Hilfsisolatorschicht liegenden Schichtstapel aller leitenden Lamellenschichten (3) selektiv zu den Isolatorschichten (17,18) entfernt, wobei im Bereich des steilflankigen Durchbruchs die oberen Enden der vertikalen Lamellen (3) freigelegt und voneinander getrennt werden,
daß anschließend mittels eines, gegenüber den Lamellen- und Bodenplattenschichten selektiven, isotropen Ätzverfahrens die zwischen den vertikalen Lamellen (3) eingebetteten Opferisolatorschichten (18) und zugleich die dicke Hilfsisolatorschicht (17) vollständig entfernt werden,
daß nachfolgend die Bodenplattenbasisschicht (2a) durch anisotropes Plasmaätzen, bei dem die Speicherelektrode (1) als selbstjustierende Ätzmaske wirkt, außerhalb der Speicherelektrode entfernt wird, wodurch die elektrische Trennung der Speicherelektroden aller Speicherzellen untereinander realisiert wird, wobei gleichzeitig die Speicherelektrode in ihren Vertikalabmessungen um den Betrag der Dicke der Bodenplattenbasisschicht (2a) abgetragen wird,
daß anschließend durch Ätz- und Reinigungsschritte die freiliegenden Oberflächen der Speicherelektrode (1) gereinigt und geglättet werden,
daß danach auf der dreidimensional ausgebildeten Oberfläche der Speicherelektrode durch Oxidations- und Abscheideprozesse ein dünnes, gleichförmig bedeckendes Speicherdielektrikum (4) hergestellt wird,
daß anschließend eine leitfähige Schicht abgeschieden wird, die die verbleibenden Zwischenräume zwischen den Lamellen (3) der Speicherelektrode vollständig ausfüllt und eine Zellplatte (5) bildet,
daß nachfolgend durch einen Abscheideprozeß eine planarisierende Deckisolatorschicht (19) ausgebildet wird, und
daß anschließend die Speicherzelle durch weitere Prozeßschritte komplettiert wird.

5. Verfahren nach Anspruch 4, dadurch gekennzeichnet, daß nach Herstellung der allseitig isolierten Wortleitung (12) und der Source- (7) und Draingebiete (9) eine untere Isolatorsschicht (11) abgeschieden wird,
daß anschließend in diese über eine Lackmaske mittels eines Plasmaätzschrittes Drainkontaktfenster (10) eingebracht werden,
daß nachfolgend der stacked-capacitor-Speicher kondensator hergestellt wird, beginnend mit der Abscheidung der Bodenplattenbasisschicht (2a), die das Draingebiet (9) kontaktiert bis zur Abscheidung einer planarisierenden Deckisolatorschicht (19),
daß anschließend in diese über dem Sourcegebiet (7) mittels eines anisotropen Plasmaätzschrittes ein Bitleitungskontaktfenster (8) eingebracht wird, wobei der Ätzprozeß auf der Zellplattenschicht (5) selektiv stoppt,
daß danach mittels eines weiteren Plasmaätzschrittes die Zellplattenschicht (5) im Bitleitungskontaktfenster (8) durchgeätzt wird, wobei das Speicherdielektrikum (4) dem Prozeß stoppt,
daß anschließend mittels eines selektiven, isotropen Ätzprozesses die im Bitleitungskontaktfenster (8) freiliegenden Flanken der Zellplattenschicht (5) hinter die Flanken der Deckisolatorschicht (19) des Bitleitungskontaktfensters (8) zurückgeätzt werden,
daß nachfolgend eine dünne Isolatorspacerschicht (20) isotrop abgeschieden wird,
daß diese anschließend auf der Oberfläche der Deckisolatorschicht (19), und auf der Bodenfläche des Bitleitungskontaktfensters (8) durch einen maskenfreien, anisotropen Plasmaätzschritt wieder entfernt wird,
daß dieser anisotrope Plasmaätzschritt darüberhinaus das Bitleitungskontaktfenster (8) bis auf die Oberfläche des Sourcegebietes (7) des einkristallinen Halbleitersubstrates vollständig öffnet, wobei die dünne Isolatorschicht (20) an den zurückgeätzten Flanken der Zellplattenschicht (5) des Bitleitungskontaktfensters (8) erhalten bleibt,
daß danach eine leitfähige Schicht isotrop abgeschieden wird, die das Bitleitungskontaktfenster (8) vollständig ausfüllt,
daß die leitfähige Schicht anschließend durch einen planarisierenden Plasmaätzprozeß bis etwa auf das Niveau der Oberfläche der planarisierenden Deckisolatorschicht (19) zurückgeätzt wird, so daß die leitfähiger Schicht im Bitleitungskontaktfenster (8) als planarisierter, leitfähiger Stempel (21) verbleibt,
daß nachfolgend die Bitleitung (6) ausgebildet wird, die den leitfähigen Stempel (21) des Bitleitungsfensters (8) kontaktiert, und
daß anschließend die Speicherzelle in herkömmlicher Weise fertigpräpariert wird.

## Claims

1. One-transistor storage cell for very large scale integrated dynamic semiconductor memories, consisting of a field isolation region and an active region on a single crystal semiconductor substrate, with a MOS field effect transistor with a wordline (12) and a source (7) and a drain area (9), a bitline (6), contacting the source area (7) and a storage node (1) of a stacked storage capacitor, contacting the drain area (9) and a cover electrode (5) of the stacked capacitor, which is the common cell plate of all storage cells of the storage matrix block, whereby the storage cell has a special design,
consisting in a storage node (1) as an concentric arrangement of closed circular lamellas (3), which are conductive, having uniform and equal thickness and distance and which are vertically arranged relative to the surface of the single crystalline semiconductor substrate,
while the inner lamella (3B) fills the centre of the storage node (1),
and each of the lamella (3) close to the semiconductor substrate surface changes into its bottom plate (2), completing each of the circular lamella (3) at the bottom thus each lamella (3) together with its bottom plate (2) forming a cup element,
and each of the bottom plate (2) on the whole area, which is enclosed by its lamella (3) contacts the next below, a larger bottom plate (2) of the next larger neighboring lamella (3), while the lowest of the bottom plates (2), which area is defined by the circumference of the most outward lamella (3a), contacts an equal sized bottom base plate (2a), which thickness is smaller than that of the lamellas (2), mediating the contact of the storage node (1) to the drain area (9) of the MOS field effect transistor,
and the storage node (1) ist conformably covered by a thin storage dielectric film (4) and by a cell plate layer (5) in such a manner, that the space between the lamellas (3) is entirely filled, while the outer flanks of the storage node (1) and the area between neighboring storage nodes (1) are covered with the cell plate (5) too, except the designed breaches areas.

2. One-transistor storage cell after 1., characterized thereby, that the lamellas (3) end in the same height above the surface of the semiconductor substrate, independent from relief topography of their bottom plates (2).

3. One-transistor storage cell after 1., 2. characterized thereby, that a bitline (6) is isolated arranged on the stacked storage capacitor, that the part of the bitline (6) located within the source contact window (8) is a plug, which is planarized to the bitline level, and that the drain contact of the storage node (1) is realized by means of a direct contact of its bottom base plate (2a) to the drain area (9).

4. Process for manufacturing a one-transistor storage cell memory after 1., 2. characterized thereby,
that after preparation of the MOS field effect transistor with its all around isolated wordline (12) and its source (7) and its drain area (9) and after deposition of an interlevel isolation layer and opening of the drain contact window (10) a thin bottom base plate layer (2a) is deposited, followed by deposition and planarization of a thick auxiliary isolation layer (17), which thickness defines the heights of the storage node (1),
after that a steep window down to the bottom base plate (2a) is etched, which circumference defines the circumference of the storage node (1),
that after that a lamella layer (3) with a thickness larger than that of the bottom base plate layer (2a), followed by a sacrificial isolation layer (18) with a thickness comparable to the lamella layer (3) are deposited, followed by anisotropic plasma etching, at least after the deposition of the sacrificial isolation layer (18), selectively stopping on the lamella layer (3), entirely etching off all of the horizontal sacrificial isolation layer regions, resulting in an almost unchanged sacrificial isolation layer vertical part along the steep flank of the lamella layer (3),
that after manifold repetition of this double-layer-deposition-and-etch-back-sequence within the steep window on the bottom base plate (2a) an arrangement of concentric conductive lamellas (3) separated by sacrificial isolation layers (18) is built,
that after deposition of the last conductive lamella layer (3b) completely filling the steep window within the thick auxiliary isolation layer (17) the horizontal layer stack of all lamella layers (3) down to the surface of the thick auxiliary isolation layer (17) is etched off by means of anisotropic plasma etching, with a selective stop on the isolation layers surfaces (17, 18), thus opening and separating the upper ends of the vertical lamellas (3),
that following the sacrificial isolation layers (18), embedded between the vertical lamellas (3) together with the thick auxiliary isolation layer (17) entirely are etched off by means of isotropic etching with high selectivity to the lamellas (3) and its bottom plates (2),
that after that the bottom base plate (2a) is etched off by anisotropic plasma etching outside the storage node (1), which thereby acts as a self aligned etch mask, thus all the storage nodes (1) of all storage cells are separated electrically, while the heights of the storage nodes (1) are decreased by the amount of the bottom base plate thickness,
after that the free surface of the storage nodes (1) are cleaned and smoothed by means of etching and cleaning steps,
after that a thin conformably covering storage dielectric film (4) on the threedimensional topographic built surface of the storage node (1) is made by oxidation and deposition processes,
followed by deposition of a conductive layer, completely filling up the remaining distances between the lamellas (3) of the storage node (1), forming a cell plate (5), after that a planarized covering isolation layer (19) is deposited followed by usual process steps, completing the storage cell.

5. Manufacturing process after 4., characterized thereby, that after processing of the all around isolated wordline (12) and the source (7) and drain areas (9) a bottom isolation layer (11) is deposited,
after that therein drain contact windows (10) are opend by means of plasma etching using a resist mask
followed by processing the stacked storage capacitor as described, starting with the deposition of the bottom base plate layer (2a) contacting the drain area (9) up to the deposition of the planarized cover isolation layer (19),
after that on the source area (7) a bitline contact window (8) is opend through the isolation layer (19) by means of an anisotropic plasma etch process, stopping selectively on the cell plate layer (5),
followed by its etching through within the bitline contact window (8), by means of another plasma etch process, stopping on the storage dielectric film (4),
after that the flanks of the cell plate layer (5) which are open along the wall of the bitline contact window (8) horizontally are etched back by means of a selective isotropic etching process up to a distance behind the flank of the cover isolation layer (19) within the bitline contact window (8)
followed by an isotropic deposition of a thin isolation spacer layer (20), and its etching off on the horizontal surface of the cover isolation layer (19) and on the bottom of the bitline contact window (8) by means of a maskless anisotropic plasma etch process, which further entirely opens the bitline contact window (8) down to the surface of the source area (7) of the single crystalline semiconductor substrate, remaining the thin isolation layer (20) at the backetched flank of the cell plate (5) within the bitline contact window (8) unchanced,
that after that a conductive layer is isotropically deposited, entirely filling the bitline contact window (8),
followed by a planarized etch back of the conductive layer down to the level of the surface of the planarized cover isolation layer (19) by anisotropic plasma etching, leaving the conductive layer within the bitline contact window (8) as a planarized conductive plug (21),
after that the bitline (6) is formed, contacting the conductive plug (21) of the bitline contact window
followed by conventional processes of completing the memory cell.

## Revendications

1. Dispositif de cellules de mémoire à transistor unique pour une mémoire semiconductrice dynamique à intégration maximale, composé d'une zone à isolation de champ et d'une zone active d'un substrat semiconducteur monocristallin, dans lequel sont intégrés un transistor sélecteur à effet de champ à sélection MOS avec une ligne de mots (12), une région de source (7) et une région de drain (9), d'une ligne de bits (6) contactée par la région de source (7) et d'une électrode de stockage (1) d'un condensateur de mémoire à capacité empilée, contactée par la région de drain (9), dont l'électrode chapeau (5) est conçue sous forme de plaque de cellule de toutes les cellules de mémoire d'un bloc de matrice de mémoire, le dispositif de cellules de mémoire étant sélectionné de sorte
que l'électrode de stockage (1) se compose d'un agencement concentrique de lamelles (3) conductrices à fermeture annulaire, orienté verticalement par rapport à la surface du substrat semiconducteur monocristallin, dont l'épaisseur de paroi et la distance mutuelle sont équidistantes et de taille à peu prés égale,
que la lamelle la plus interne (3B) remplit entièrement le centre de l'électrode de stockage (1),
que chacune des lamelles (3) passe dans une couche de plaques de fond (2), en direction du substrat semiconducteur, chacune des lamelles annulaires (3) étant ainsi fermée vers le bas et formant, avec sa couche de plaques de fond (2), un élément en forme de godet,
que chacune de ces couches de plaques de fond (2) contacte sur l'ensemble de la surface renfermée par la lamelle correspondante (3) la couche de plaques de fond plus grande sous-jacente (2) de la lamelle adjacente plus grande (3),
que la couche de plaques de fond située la plus en bas (2), dont la surface est déterminée par l'étendue de la lamelle la plus externe (3A), contacte une couche de base de plaques de fond de même taille (2A), établissant le contact avec la région de drain (9) du transistor sélecteur MOS (2A), l'épaisseur de cette couche étant inférieure à celle d'une couche de plaques de fond (2),
que l'électrode de stockage (1) est recouverte d'une fine couche conforme de diélectrique de stockage (4) et d'une couche de plaques de cellules (5), les espaces restants entre les lamelles (3) et l'électrode de stockage (1) de chaque cellule de mémoire étant ainsi remplis entièrement par la couche de plaques de cellules (5) et les flancs extérieurs de l'électrode de stockage (1) ainsi que les espaces entre les électrodes de stockage (1) de cellules de mémoire voisines étant également recouverts de la plaque de cellule (5), à l'exception de percées dues à la conception.

2. Dispositif de cellules de mémoire à transistor unique selon la revendication 1, caractérisé en ce que les lamelles (3) se terminent à un niveau uniforme, au-dessus du niveau de la surface du substrat semiconducteur, indépendamment du relief de leurs couches de plaques de fond (2) et indépendamment du relief des éléments de cellules de mémoire agencées au-dessous.

3. Dispositif de cellules de mémoire à transistor unique selon l'une quelconque des revendications précédentes, caractérisé
en ce qu'une ligne de bits (6) est agencée de façon isolée sur le condensateur de mémoire à capacité empilée, la partie (21) de la ligne de bits (6) agencée dans l'ouverture de contact de source (8) étant configurée sous forme d'empreinte et étant aplanie par rapport au niveau de la ligne de bits, I'établissement du contact entre le drain et l'électrode de stockage (1) se faisant par l'intermédiaire d'un contact direct entre la couche de base des plaques de fond (2a) et la région de drain (9).

4. Procédé de production d'un dispositif de cellules de mémoire à transistor unique selon les revendications 1 et 2, caractérisé
en ce qu'après la production du transistor sélecteur à effet de champ MOS, avec une ligne de mots isolée de tous les côtés (12) et des régions de source (7) et de drain (9), et après la séparation d'un isolateur de plan intermédiaire et l'établissement d'une ouverture de contact de drain (10), une mince couche de base de plaques de fond (2a) ainsi qu'une couche isolante auxiliaire épaisse (17), dont l'épaisseur définit la dimension verticale de l'électrode de stockage (1), sont aplanies et séparées,
en ce qu'une percée à flanc raide est ensuite pratiquée dans cette dernière, jusqu'à la couche de base des plaques de fond (2a), par l'intermédiaire d'une gravure au plasma sélective anisotrope, I'étendue de cette percée déterminant la dimension externe de l'électrode de stockage (1),
en ce que, en commençant par la séparation d'une première couche de lamelles conductrices (3A) on sépare ensuite alternativement une couche de lamelles (3), d'une épaisseur supérieure à l'épaisseur de la couche de base des plaques de fond (2A), et une couche isolante sacrificielle (18), d'une épaisseur comparable à l'épaisseur d'une couche de lamelles (3), un processus de gravure en retrait plasma-chimique anisotrope étant effectué au moins après la séparation de la couche isolante sacrificielle (18), ce processus s'arrêtant sélectivement au niveau de la couche de lamelles (3) séparée en dernier lieu, les régions de couche horizontales de la couche isolante sacrificielle (18) étant ainsi entièrement éliminées, la couche isolante sacrificielle (18) étant toutefois maintenue sur la paroi verticale de la percée à flanc raide, de sorte à y former après plusieurs répétitions desdits procédés de séparation de couche et de gravure en retrait, une structure de lamelles verticale composée de lamelles conductrices (3) et de couches isolantes sacrificielles (18) agencées entre celles-ci,
en ce qu'après la séparation de la dernière des couches de lamelles conductrices (3B), fermant complètement la percée à flanc raide dans la couche isolante auxiliaire épaisse (17), on réalise une étape de gravure au plasma anisotrope, éliminant la pile stratifiée de toutes les couches de lamelles conductrices (3) agencées sur la surface de la couche isolante auxiliaire épaisse, de façon sélective par rapport aux couches isolantes (17, 18), les extrémités supérieures des lamelles verticales (3) agencées au niveau de la percée à flanc raide étant ainsi dégagées et séparées les unes des autres,
en ce que les couches isolantes sacrificielles (18) enrobées entre les lamelles verticales (3), ainsi que la couche isolante épaisse (17) sont ensuite éliminées complètement au moyen d'un procédé de gravure isotrope sélective par rapport aux couches de lamelles (3) et de plaques de fond (2),
en ce que la couche de base des plaques de fond (2A) est ensuite éliminée en-dehors de l'électrode de stockage (1) par une gravure au plasma anisotrope, lors de laquelle l'électrode de stockage (1) sert de masque de gravure à auto-ajustement, réalisant ainsi la séparation électrique des électrodes de stockage (1) de toutes les cellules de mémoire, les dimensions verticales de l'électrode de stockage (1) étant simultanément réduites de la valeur de l'épaisseur de la couche de base des plaques de fond (2A),
en ce que les surfaces dégagées de l'électrode de stockage (1) sont ensuite nettoyées et lissées au cours d'étapes de gravure et de nettoyage,
en ce qu'une diélectrique de stockage fine, à couverture régulière (4), est agencée ensuite sur la surface tridimensionnelle de l'électrode de stockage (1) par des procédés d'oxydation et de séparation,
en ce qu'une couche conductrice, remplissant entièrement les espaces restants entre les lamelles (3) de l'électrode de stockage (1) et formant une plaque de cellule (5) est alors séparée,
en ce qu'une couche isolante de couverture d'aplanissement (19) est ensuite formée par un procédé de séparation, et
en ce que la cellule de mémoire est alors complétée au cours des étapes ultérieures du processus.

5. Procédé selon la revendication 4, caractérisé en ce qu'une couche isolante inférieure (11) est séparée après la production de la ligne de mots isolée de tous les côtés (12) et des régions de source (7) et de drain (9),
en ce que des ouvertures de contact de drain (10) sont ensuite appliquées dans celle-ci par l'intermédiaire d'un masque de vernis au cours d'un procédé de gravure au plasma,
en ce que le condensateur de mémoire à capacité empilée est alors produit, en commençant par la séparation de la couche de base des plaques de fond (2a), contactant la région de drain (9), jusqu'à la séparation d'une couche isolante de couverture d'aplanissement (19),
en ce qu'une ouverture de contact de la ligne de bits (8) est ensuite pratiquée dans celle-ci au-dessus de la région de source (7) au cours d'une étape de gravure au plasma anisotrope, le procédé de gravure étant arrêté sélectivement sur la couche des plaques de cellule (5),
en ce que la couche des plaques de cellule (5) est alors gravée dans l'ouverture de contact de la ligne de bits (8) au cours d'une étape ultérieure de gravure au plasma, la diélectrique de stockage (4) arrêtant le procédé,
en ce que les flancs dégagés de la couche des plaques de cellule (5) dans l'ouverture de contact de la ligne de bits (8) sont gravés en retrait derrière les flancs de la couche isolante de couverture (19) de l'ouverture de contact de la ligne de bits (8), au cours d'un procédé de gravure isotrope sélective,
en ce qu'une mince couche isolante d'espacement (20) est ensuite séparée de façon isotrope,
en ce que celle-ci est alors de nouveau éliminée sur la surface horizontale de la couche isolante de couverture (19) et sur la surface de base de l'ouverture de contact de la ligne de bits (8) au cours d'une étape de gravure au plasma anisotrope sans masque,
en ce que cette étape de gravure au plasma anisotrope ouvre en outre complètement l'ouverture de contact de la ligne de bits (8) jusqu'à la surface de la région de source (7) du substrat semiconducteur monocristallin, la mince couche isolante (20) étant maintenue sur les flancs gravés en retrait de la couche de plaques de cellule (5) de l'ouverture de contact de la ligne de bits (8),
en ce qu'une couche conductrice est ensuite séparée de façon isotrope, celle-ci remplissant entièrement l'ouverture de contact de la ligne de bits (8),
en ce que la couche conductrice est alors gravée en retrait par un procédé de gravure au plasma d'aplanissement, à peu près jusqu'au niveau de la surface de la couche isolante de couverture d'aplanissement (19), de sorte que la couche conductrice est maintenue dans l'ouverture de contact de la ligne de bits (8) sous forme d'une empreinte conductrice aplanie (21)
en ce que la ligne de bits (6), contactant l'empreinte conductrice (21) de l'ouverture de la ligne de bits (8) est ensuite formée, et
en ce que la préparation de la cellule de mémoire est alors achevée de façon conventionnelle.
